# EUROPEAN PATENT APPLICATION

(11) **EP 4 542 726 A1**
(43) Date of publication of application: **23.04.2025**
(21) Application number: 23896233.6
(22) Date of filing: 26.09.2023
(51) Int. Cl.: H01M 10/48, G01B 11/16, G01K 11/32, G01R 31/396

(54) **BATTERY CELL, BATTERY, AND ELECTRIC APPARATUS**

(30) Priority: 01.12.2022 CN 202211531135
(71) Applicant: Contemporary Amperex Technology Co., Limited, Ningde, Fujian 352100 (CN); Jinan University, Tianhe District Guangzhou Guangdong 510632 (CN)
(72) Inventor: GUO, Tuan, Ningde, Fujian 352100 (CN); LEI, Meina, Ningde, Fujian 352100 (CN); CHEN, Zhishan, Ningde, Fujian 352100 (CN); HAN, Xile, Ningde, Fujian 352100 (CN); LIU, Yubin, Ningde, Fujian 352100 (CN); LIU, Zhi, Ningde, Fujian 352100 (CN); LIN, Zhen, Ningde, Fujian 352100 (CN); LI, Wei, Ningde, Fujian 352100 (CN); WU, Kai, Ningde, Fujian 352100 (CN)
(74) Representative: Kraus & Lederer PartGmbB
(86) International application number: PCT/CN2023/121741
(87) International publication number: WO 2024/114076

(57) **Abstract**

Disclosed are a battery cell (7), a battery (2), and an electric apparatus. The battery cell (7) includes a housing (20), an electrode assembly (11), and an optical fiber (8). The electrode assembly (11) is accommodated in the housing (20). The optical fiber (8) includes a first section (81) and a second section (82). The first section (81) is attached to the electrode assembly (11), the second section (82) is connected to the first section (81) and extends out of the housing (20), and an axis of the first section (81) is staggered with an axis of the second section (82). The optical fiber (8) is configured to obtain a status signal of the battery cell (7). **In** embodiments of this application, the temperature change and strain of the battery cell can be monitored simultaneously, improving the operation safety and stability of the battery cell (7).

## Description

### CROSS-REFERENCE TO RELATED APPLICATIONS

This application claims priority to Chinese Patent Application No. 202211531135.1, filed on December 1, 2022 and entitled "BATTERY CELL, BATTERY, AND ELECTRIC APPARATUS", which is incorporated herein by reference in its entirety.

### TECHNICAL FIELD

This application relates to the field of batteries, and in particular, to a battery cell, a battery, and an electric apparatus.

### BACKGROUND

Battery cells are widely used in electronic devices, such as mobile communication devices, laptop computers, electric motorcycles, electric vehicles, electric airplanes, electric ships, electric toys, electric airplanes, or electric tools. The battery cells may include nickel-chromium battery cells, nickel-hydrogen battery cells, lithium-ion battery cells, secondary alkaline zinc-manganese battery cells, or the like.

At present, how to improve the safety performance of the battery cell and how to monitor the operating status of the battery cell in time are also key research focuses in this field.

### SUMMARY

In view of the above problems, this application provides a battery cell, a battery, and an electric apparatus, which can monitor the operating status of the battery cell, improving the operation safety and stability of the battery cell.

According to a first aspect, this application provides a battery cell, including a housing, an electrode assembly, and an optical fiber. The electrode assembly is accommodated in the housing. The optical fiber includes a first section and a second section. The first section is attached to the electrode assembly, the second section is connected to the first section and extends out of the housing, and an axis of the first section is staggered with an axis of the second section. The optical fiber is configured to obtain a status signal of the battery cell.

In the technical solution of the embodiments of this application, the optical fiber includes the first section and the second section being connected to each other, and the first section is attached to the electrode assembly, which can improve the detection sensitivity of the optical fiber to the temperature or strain of the electrode assembly, thereby improving the accuracy and efficiency in monitoring the status of the battery cell. The second section extends out of the housing to transmit the internal status information of the electrode assembly to the outside. The axes of the first section and the second section are staggered, and the second section does not contact the electrode assembly. Due to the photo-thermal effect, the central wavelength of the Bragg mode and the central wavelength of the Ghost mode of the single-mode optical fiber change, and these changes can reflect the thickness changes and surface temperature changes of the electrode assembly. Therefore, the above structure can monitor the temperature change and strain of the battery cell simultaneously, improving the operation safety and stability of the battery cell.

In some embodiments, the status signal includes a Ghost signal and a Bragg signal. The Ghost signal is used for obtaining strain information of the battery cell and the Bragg signal is used for obtaining temperature information of the battery cell. As changes in the Ghost signal and Bragg signal of the single-mode optical fiber are obtained, where these signals feature high sensitivity and fast speed in testing the strain and temperature changes of the battery cell, the change in status information of the battery cell can be monitored effectively.

In some embodiments, a diameter of the first section is not equal to a diameter of the second section, or the diameter of the first section is equal to the diameter of the second section. In the above technical solution, the diameters of the first section and the second section being equal facilitates the manufacturing and assembly of the optical fiber. The diameters of the first section and the second section being unequal is conducive to connecting one second section to a plurality of first sections simultaneously, thereby monitoring a plurality of monitoring points of the battery cell simultaneously.

In some embodiments, a length of the second section is L₁, and 1 mm≤L₁≤2 cm. The second section is configured to connect the first section and an external signal device. Setting a reasonable length of the second section can ensure the transmission of the information collected by the first section while reducing the space occupied by the second section.

In some embodiments, the first section and the second section are connected through welding. The welding for connection can ensure the stability of signal transmission in the light and the connection strength between the first section and the second section. Additionally, the welding is simple to operate, allowing for a high connection efficiency.

In some embodiments, the optical fiber further includes a third section, the third section is connected to an end of the first section away from the second section, and a Bragg grating is disposed on the third section. Arranging the Bragg grating in the optical fiber can obtain spectrum information including the Bragg mode and Ghost mode. The intensity change of the Ghost mode in the Bragg grating spectrum is in a certain strain relationship with strain, and the Bragg wavelength shift in the Bragg grating spectrum is in a certain strain relationship with temperature. A spectrometer analyzes the spectra of the two modes simultaneously to obtain the strain and temperature change information of the battery cell under test.

In some embodiments, the third section and the second section form an integral structure. The above structure can improve the manufacturing efficiency of the third section.

In some embodiments, a length of the third section is L₂, and 1 mm≤L₂≤5 cm. Setting a reasonable length of the third section can ensure the accuracy of the spectral signal while minimizing the space occupied by the third section.

In some embodiments, the electrode assembly includes electrode plates and separators being stacked, and at least part of the third section is disposed between the electrode plate and the separator of the battery cell, or at least part of the third section is disposed between two of the separators of the battery cell. Setting the optical fiber in the above position can more accurately obtain the local temperature and thickness changes during the operation of the battery cell, further improving the monitoring efficiency and accuracy of the battery cell.

In some embodiments, such second section is provided in plurality, the plurality of second sections are connected to at least one such first section, and the second sections are each connected to at least one such electrode assembly. Each second section can obtain information at least one monitoring point, and a plurality of second sections can simultaneously obtain a plurality of pieces of monitoring information. Based on the above structure, a plurality of monitoring points may be disposed on the same battery cell or on a plurality of battery cells, respectively. The same first section can connect a plurality of second sections. Monitoring points of the battery cell are added to the foregoing structure, simplifying the structure of the first section, ensuring the transmission of spectral signals, simplifying the optical fiber structure, and improving the efficiency of information transmission.

According to a second aspect, an embodiment of this application provides a monitoring method for a battery cell, which is used for monitoring status information of the battery cell. The monitoring method includes:
obtaining initial status information of the battery cell based on an initial detection signal of an optical fiber, where the initial status information includes an initial Ghost mode signal and an initial Bragg mode signal;
obtaining first status information of the battery cell based on a first detection signal of the optical fiber, where the first status information includes a first Ghost mode signal and a first Bragg mode signal;
obtaining strain information of a battery based on a difference between the initial Ghost mode signal and the first Ghost mode signal; and
obtaining temperature change information of the battery based on a difference between the initial Bragg mode signal and the first Bragg mode signal.

Through the above detection method, pieces of information about local temperature change and thickness change of the battery cell can be obtained simultaneously, with fast acquisition speed and high accuracy, enabling real-time monitoring of the status of the battery cell, and ensuring the safety and stability of operation of the battery cell.

In some embodiments, the initial Ghost mode signal is a maximum intensity value M₀ of a Ghost mode spectrum at a time T₀, and the first Ghost mode signal is a maximum intensity value M₁ of the Ghost mode spectrum at a time T₁. A difference between the maximum intensity value M₀ of the Ghost mode spectrum at the initial time and the maximum intensity value M₁ of the Ghost mode spectrum at the time T₁ can be calculated to obtain thickness change information of the battery cell.

In some embodiments, the initial Bragg mode signal is a wavelength λ₀ corresponding to a maximum intensity value of a Bragg mode spectrum at a time T₀ and the first Bragg mode signal is a wavelength λ1 corresponding to a maximum intensity value of the Bragg mode spectrum at a time T₁. The difference between the wavelength λ₀ corresponding to the maximum intensity value of the Bragg mode spectrum at the time T₀ and the wavelength λ₁ corresponding to the maximum intensity value of the Bragg mode spectrum at the time T₁ can calculated to obtain the temperature change information of the battery cell.

In some embodiments, the following steps are performed to obtain the temperature change information ΔT₁:
obtaining a wavelength difference Δλ₁ between the wavelength λ₁ corresponding to the maximum intensity value of the Bragg mode spectrum at the time T₁ and the wavelength λ₀ corresponding to the maximum intensity value of the Bragg mode spectrum at the time T₀, and
obtaining the temperature change information ΔT₁ based on the wavelength difference Δλ₁, where the temperature change information _{Δ}T₁ is in a direct proportional relationship with the wavelength difference Δλ₁, and temperature changes by 1°C for every 10 pm-14 pm shift in a Bragg mode wavelength.

In some embodiments, the following steps are performed to obtain the strain information ΔL₁:
obtaining an intensity difference _{Δ}M₁ between the maximum intensity value M₀ of the Ghost mode spectrum at the time T₀ and the maximum intensity value M₁ of the Ghost mode spectrum at the time T₁,
obtaining stress information _{Δ}F₁ based on the intensity difference ΔM₁, where the intensity difference ΔM₁ is in a direct proportional relationship with the stress information ΔF₁, and stress increases by 1 N for every 0.22-0.23 dB decrease in intensity, and
obtaining the strain information ΔL₁ based on the stress information ΔF₁ and a Young modulus of the optical fiber.

According to a third aspect, an embodiment of this application provides a battery, including the battery cell in any of the above embodiments, a signal transmitting device, a signal receiving device, and a signal analyzing device. The signal transmitting device is connected to the second section of the optical fiber of the battery cell, where the signal transmitting device is configured to transmit a detection signal to the optical fiber. The signal receiving device is connected to the second section of the optical fiber, where the signal receiving device is configured to receive a status signal transmitted back by the optical fiber. The signal analyzing device is connected to the signal receiving device and configured to convert the status signal to status information of the battery cell.

In the above technical solution, the signal transmitting device can transmit a signal to an optical fiber, the signal receiving device can receive a status signal reflected from the optical fiber, and the signal analyzing device converts the status signal into status information to obtain the real-time temperature change and thickness change values of the battery cell.

According to a fourth aspect, an embodiment of this application provides an electric apparatus, including the battery in any one of the foregoing embodiments, where the battery is configured to supply electrical energy.

The foregoing description is merely an overview of the technical solution of this application. For a better understanding of the technical means in this application such that they can be implemented according to the content of the specification, and to make the above and other objectives, features, and advantages of this application more obvious and easier to understand, the following describes specific embodiments of this application.

### BRIEF DESCRIPTION OF DRAWINGS

The following describes features, advantages, and technical effects of the example embodiments of this application with reference to the accompanying drawings.
FIG. 1 is a schematic structural diagram of a vehicle according to an embodiment of this application;
FIG. 2 is a schematic exploded view of a battery according to an embodiment of this application;
FIG. 3 is a schematic exploded view of a battery cell in the battery according to an embodiment of this application;
FIG. 4 is a schematic structural diagram of an optical fiber of the battery cell according to an embodiment of this application;
FIG. 5 is a spectrogram of the optical fiber of the battery cell according to an embodiment of this application;
FIG. 6 is a schematic structural diagram of the optical fiber of the battery cell according to an embodiment of this application;
FIG. 7 is a schematic structural diagram of connection of a tape and a third section of the battery cell according to an embodiment of this application;
FIG. 8 is a flowchart of a monitoring method for a battery cell according to an embodiment of this application;
FIG. 9 is a strain graph of the optical fiber of the battery cell to temperature according to an embodiment of this application;
FIG. 10 is a fitting curve of a Bragg peak with temperature change in FIG. 9;
FIG. 11 is a temperature change graph during charge and discharge of the battery cell at a charge and discharge rate of 0.33C according to Embodiment 2 of this application;
FIG. 12 is a temperature change graph during charge and discharge of the battery cell at a charge and discharge rate of 0.75C according to Embodiment 2 of this application;
FIG. 13 is a temperature change graph during charge and discharge of the battery cell at a charge and discharge rate of 1.0C according to Embodiment 2 of this application;
FIG. 14 is a strain graph of the optical fiber of the battery cell to stress according to an embodiment of this application;
FIG. 15 is a fitting curve of a Ghost mode peak intensity with pressure change in FIG. 14;
FIG. 16 is a stress change spectrum during charge and discharge of the battery cell at a charge and discharge rate of 0.33C according to Embodiment 4 of this application;
FIG. 17 is a stress change spectrum during charge and discharge of the battery cell at a charge and discharge rate of 0.75C according to Embodiment 4 of this application; and
FIG. 18 is a stress change spectrum during charge and discharge of the battery cell at a charge and discharge rate of 1.0C according to Embodiment 4 of this application.

Numeral references are described in detail:
1. vehicle; 10. electrode unit; 11. electrode assembly; 2. battery; 20. housing; 21. opening; 24. pressure relief mechanism; 25. electrode terminal; 3. controller; X. Ghost signal; Y. Bragg signal; 4. motor; 5. box; 51. first portion; 52. second portion; 53. accommodating space; 7. battery cell; 8. optical fiber; 81. first section; 82. second section; and 83. tape.

### DESCRIPTION OF EMBODIMENTS

To make the objectives, technical solutions, and advantages of the embodiments of this application clearer, the following clearly describes the technical solutions in the embodiments of this application with reference to the accompanying drawings in the embodiments of this application. Apparently, the described embodiments are some but not all of the embodiments of this application. All other embodiments obtained by persons of ordinary skill in the art based on the embodiments of this application without creative efforts shall fall within the protection scope of this application.

Unless otherwise defined, all technical and scientific terms used in this application shall have the same meanings as commonly understood by persons skilled in the art to which this application relates. The terms used in the specification of this application are intended to merely describe the specific embodiments rather than to limit this application. The terms "include", "comprise", and any variations thereof in the specification, claims, and brief description of drawings of this application are intended to cover non-exclusive inclusions. In the specification, claims, or accompanying drawings of this application, the terms "first", "second", and the like are intended to distinguish between different objects rather than to describe a particular order or a primary-secondary relationship.

Reference to "embodiment" in this application means that specific features, structures, or characteristics described with reference to the embodiment may be included in at least one embodiment of this application. The word "embodiment" appearing in various places in this specification does not necessarily refer to the same embodiment or an independent or alternative embodiment that is exclusive of other embodiments.

In the description of this application, it should be noted that unless otherwise specified and defined explicitly, the terms "mount", "connect", "join", and "attach" should be understood in their general senses. For example, they may refer to a fixed connection, a detachable connection, or an integral connection; and a direct connection, an indirect connection via an intermediate medium, or an internal communication between two elements. Persons of ordinary skill in the art can understand specific meanings of these terms in this application as appropriate to specific situations.

The term "and/or" in this application is only an associative relationship for describing associated objects, indicating that three relationships may be present. For example, A and/or B may indicate the following three cases: presence of only A; presence of both A and B; and presence of only B. In addition, the character "/" in this application generally indicates an "or" relationship between the contextually associated objects.

In the embodiments of this application, the same reference signs denote the same components. For brevity, in different embodiments, detailed descriptions of the same components are not repeated. It should be understood that as shown in the accompanying drawings, sizes such as thickness, length, and width of various components and sizes such as thickness, length, and width of integrated devices in the embodiments of this application are merely for illustrative purposes and should not constitute any limitations on this application.

In this application, "a plurality of" means more than two (inclusive).

In this application, a battery cell may include a lithium-ion secondary battery cell, a lithium-ion primary battery cell, a lithium-sulfur battery cell, a sodium-lithium-ion battery cell, a sodium-ion battery cell, a magnesium-ion battery cell, or the like. This is not limited in the embodiments of this application. The battery cell may be cylindrical, flat, cuboid, or of other shapes. This is not limited in the embodiments of this application either. Battery cells are typically divided into three types by packaging method: cylindrical cell, prismatic cell, and pouch cell. This is not limited in the embodiments of this application either.

The battery mentioned in the embodiments of this application is a single physical module that includes one or more battery cells for providing a higher voltage and capacity. For example, the battery mentioned in this application may include a battery module, a battery pack, or the like. A battery typically includes a housing configured to package one or more battery cells. The housing can prevent liquids or other foreign matter from affecting charging or discharging of the battery cell.

The battery cell includes an electrode unit and an electrolyte, the electrode unit includes at least one electrode assembly, and the electrode assembly includes a positive electrode plate, a negative electrode plate, and a separator. The battery cell mainly relies on migration of metal ions between the positive electrode plate and the negative electrode plate to work. The positive electrode plate includes a positive electrode current collector and a positive electrode active substance layer. The positive electrode active substance layer is applied to a surface of the positive electrode current collector. The positive electrode current collector includes a positive electrode current collecting part and a positive electrode protrusion protruding from the positive electrode current collecting part. The positive electrode current collecting part is coated with the positive electrode active substance layer, at least part of the positive electrode protrusion is uncoated with the positive electrode active substance layer, and the positive electrode protrusion is used as a positive electrode tab. A lithium-ion battery is used as an example, for which, the positive electrode current collector may be made of aluminum, the positive electrode active substance layer includes a positive electrode active substance, and the positive electrode active substance may be lithium cobalt oxide, lithium iron phosphate, ternary lithium, lithium manganate oxide, or the like. The negative electrode plate includes a negative electrode current collector and a negative electrode active substance layer. The negative electrode active substance layer is applied to a surface of the negative electrode current collector. The negative electrode current collector includes a negative electrode current collecting part and a negative electrode protrusion protruding from the negative electrode current collecting part. The negative electrode current collecting part is coated with the negative electrode active substance layer, at least part of the negative electrode protrusion is uncoated with the negative electrode active substance layer, and the negative electrode protrusion is used as a negative electrode tab. The negative electrode current collector may be made of copper, the negative electrode active substance layer includes a negative electrode active substance, and the negative electrode active substance may be carbon, silicon, or the like. To allow a high current to pass through without any fusing, a plurality of positive tabs are provided and stacked together, and a plurality of negative tabs are provided and stacked together. The separator may be made of PP (polypropylene, polypropylene), PE (polyethylene, polyethylene), or the like. In addition, the electrode assembly may be a wound structure or a laminated structure. However, the embodiments of this application are not limited thereto.

For ease of description, the electric apparatus being a vehicle is used as an example for description of the following embodiments.

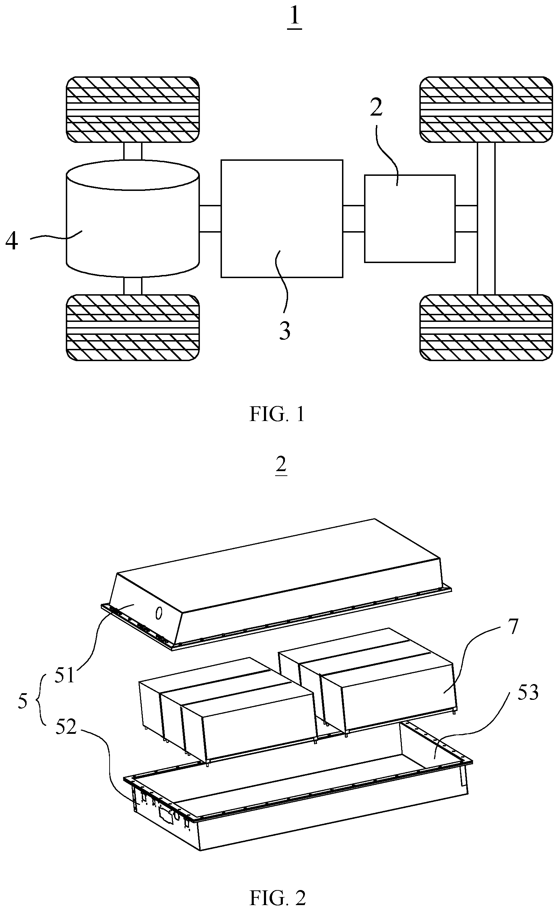

FIG. 1 is a schematic structural diagram of a vehicle according to some embodiments of this application. As shown in FIG. 1, the vehicle 1 is provided with a battery 2 inside, and the battery 2 may be disposed at the bottom or in the front or at the rear of the vehicle 1. The battery 2 may be configured to supply power to the vehicle 1. For example, the battery 2 may be used as an operational power supply for the vehicle 1.

The vehicle 1 may further include a controller 3 and a motor 4, and the controller 3 is configured to control the battery 2 to supply power to the motor 4, for example, to satisfy a working electricity need during start, navigation, and driving of the vehicle 1.

In some embodiments of this application, the battery 2 can be used as not only an operational power source for the vehicle 1 but also a traction power source for the vehicle 1, replacing or partially replacing fossil fuel or natural gas to provide driving traction for the vehicle 1.

FIG. 2 is a schematic exploded view of a battery according to some embodiments of this application. As shown in FIG. 2, the battery 2 includes a box 5 and a battery module, a plurality of battery cells form the battery module, and the battery module is accommodated in the box 5.

The box 5 is configured to accommodate the battery cell, and the box 5 may be of various structures. In some embodiments, the box 5 may include a first portion 51 and a second portion 52. The first portion 51 and the second portion 52 fit together to jointly define an accommodating space 53 for accommodating the battery cell 21. The second portion 52 may be a hollow structure with an opening at one side, the first portion 51 is a plate-shaped structure, and the first portion 51 covers the opening side of the second portion 52 to form the box 5 having the accommodating space 53. Alternatively, the first portion 51 and the second portion 52 may each be a hollow structure with an opening at one side, and the opening side of the first portion 51 fits with the opening side of the second portion 52 to form the box 5 having the accommodating space 53. Certainly, the first portion 51 and the second portion 52 may be in various shapes, such as a cylinder or a cuboid.

In order to improve air tightness after connection of the first portion 51 and the second portion 52, a sealing member, such as sealing gum and sealing ring, may further be disposed between the first portion 51 and the second portion 52.

Assuming that the first portion 51 covers the top of the second portion 52, the first portion 51 may also be referred to as an upper box cover, and the second portion 52 may also be referred to as a lower box body.

In the battery 2, one or more battery cells 7 may be provided. If a plurality of battery cells 7 are provided, the plurality of battery cells 7 may be connected in series, parallel, or series-parallel, where being connected in series-parallel means that the plurality of battery cells 7 are connected in both series and parallel. The plurality of battery cells 7 may be directly connected in series, parallel, or series-parallel, and then an entirety of the plurality of battery cells 7 is accommodated in the box 5; or certainly, the plurality of battery cells 7 may be connected in series, parallel, or series-parallel first to form a battery module, and then a plurality of battery modules are connected in series, parallel, or series-parallel to form an entirety which is accommodated in the box 5.

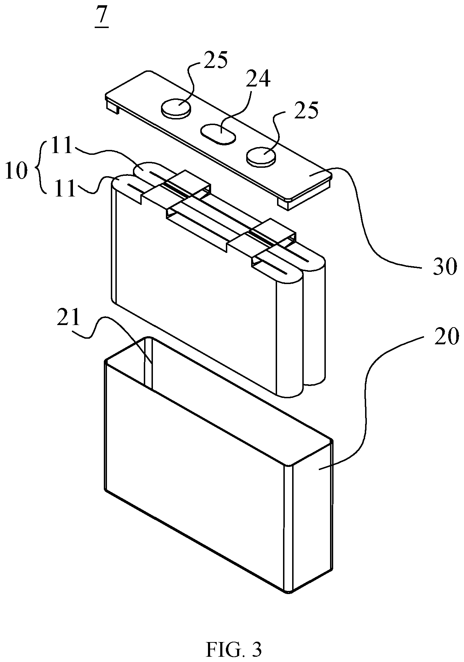

FIG. 3 is a schematic exploded view of a battery cell in a battery according to some embodiments of this application. In some embodiments, there are a plurality of battery cells 7, and the plurality of battery cells 7 are connected in series, parallel, or series-parallel to form a battery module. The plurality of battery modules are then connected in series, parallel, or series-parallel to form an entirety which is accommodated in the box. The plurality of battery cells 7 in the battery module may be electrically connected via a busbar, so that the plurality of battery cells 7 in the battery module are connected in parallel, series, or series-parallel.

According to an embodiment of this application, the battery cell 7 includes an electrode unit 10, a shell 20, and an end cover assembly 30. The shell 20 has an opening 21, the electrode unit 10 is accommodated in the shell 20, and the end cover assembly 30 is used to be connected to the shell 20 and cover the opening 21.

The electrode unit 10 includes at least one electrode assembly 11. For example, the electrode unit 10 in FIG. 3 includes two electrode assemblies 11. The electrode assembly 11 includes a positive electrode plate, a negative electrode plate, and a separator. The electrode assembly 11 may be a wound electrode assembly, a stacked electrode assembly, or an electrode assembly of another form.

The electrode unit 10 includes at least one electrode assembly 11. In other words, in the battery cell 7, one or more electrode assemblies 11 are accommodated in the shell 20.

The battery cell 7 typically includes a housing 70. The housing 70 includes a shell 20 and an end cover assembly 30. The shell 20 is of a hollow structure with an opening on one side. The end cover assembly 30 covers the opening of the shell 20 to form sealing connection so as to form an accommodating cavity for accommodating the electrode unit 10 and the electrolyte.

The end cover assembly 30 also includes an electrode terminal 25. In some embodiments, such electrode terminal 25 is provided in a quantity of two, and the two electrode terminals 25 are respectively defined as a positive electrode terminal and a negative electrode terminal. The positive electrode terminal and the negative electrode terminal are respectively configured to be electrically connected to the positive electrode tab and the negative electrode tab of the electrode assembly 11, to output the current generated by the electrode assembly 11.

The end cover assembly 30 also includes a pressure relief mechanism 24, and the pressure relief mechanism 24 is configured to release the internal pressure or temperature of the battery cell 7 when the internal pressure or temperature of the battery cell 7 reaches a predetermined value. For example, the pressure relief mechanism 24 is located between a positive electrode terminal and a negative electrode terminal, and the pressure relief mechanism 24 may be a component such as an anti-explosion valve, an anti-explosion disk, an air valve, a pressure relief valve, or a security valve.

In some embodiments, the shell 20 may further be a hollow structure with openings on two opposite sides. The end cover assembly 30 includes two end cover assemblies 30, and the two end cover assemblies 30 respectively cover the two openings of the shell 20 and are sealingly connected, so as to create an accommodating cavity for accommodating the electrode unit 10 and the electrolyte. In some examples, the positive electrode terminal and the negative electrode terminal may be mounted on the same end cover assembly 30. In other examples, the positive electrode terminal and the negative electrode terminal are respectively mounted on two end cover assemblies 30.

During the operation of the battery cell 7, the temperature of the electrode assembly 11 gradually increases. When the temperature of the electrode assembly 11 rises to a certain extent, the internal pressure of the electrode assembly also increases, greatly reducing the stability of the internal environment of the shell 20. In addition, crystallization on the surface of the electrode assembly 11 leads to an increase in the thickness thereof. When the crystallization on the surface of the electrode assembly reaches a certain extent, it may pierce the separator, causing an internal short circuit in the electrode assembly. Additionally, the increase in the thickness of the electrode assembly 11 to a certain extent causes deformation of the shell 20 and uneven distribution of the electrolyte, and also causes instable operation of the battery cell 7, leading to safety accident.

In view of the above problems, the inventors have designed a battery cell, including a housing, an electrode assembly, and an optical fiber. The electrode assembly is accommodated in the housing. In the technical solution of the embodiments of this application, the optical fiber includes the first section and the second section being connected to each other, and the first section is attached to the electrode assembly, which can improve the detection sensitivity of the optical fiber to the temperature or strain of the electrode assembly, thereby improving the accuracy and efficiency in monitoring the status of the battery cell. The second section extends out of the housing to transmit the internal status information of the electrode assembly to the outside. The axes of the first section and the second section are staggered, and the second section does not contact the electrode assembly. Due to the photo-thermal effect, the central wavelength of the Bragg mode and the central wavelength of the Ghost mode of the single-mode optical fiber change, and these changes can reflect the thickness changes and surface temperature changes of the electrode assembly. Therefore, the above structure can monitor the temperature change and strain of the battery cell simultaneously, improving the operation safety and stability of the battery cell.

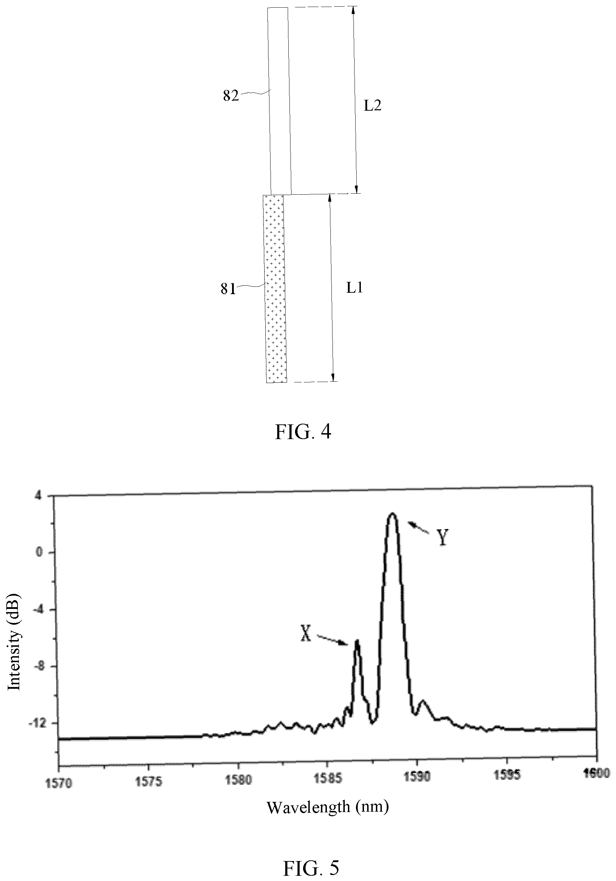

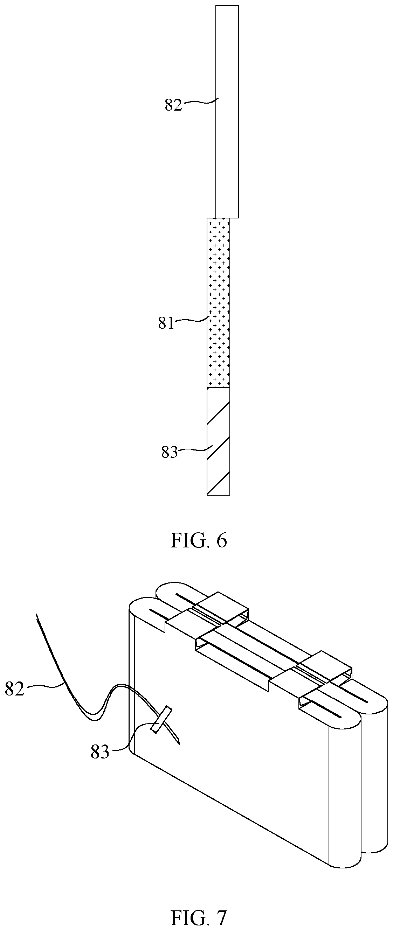

Still referring to FIGs. 4 to 7, FIG. 4 is a schematic structural diagram of an optical fiber 8 of a battery cell 7 according to an embodiment of this application; FIG. 5 is a spectrogram of the optical fiber 8 of the battery cell 7 according to an embodiment of this application; FIG. 6 is a schematic structural diagram of the optical fiber 8 of the battery cell 7 according to an embodiment of this application; and FIG. 7 is a schematic structural diagram of connection of a tape 83 and a third section connection of the battery cell 7 according to an embodiment of this application.

Referring to FIGs. 3 to 5, an embodiment of this application provides a battery cell 7, including a housing, an electrode assembly 11, and an optical fiber 8. The electrode assembly 11 is accommodated in the housing. The optical fiber 8 includes a first section 81 and a second section 82. The first section 81 is attached to the electrode assembly 11, the second section 82 is connected to the first section 81 and extends out of the housing, and an axis of the first section 81 is staggered with an axis of the second section 82. The optical fiber 8 is configured to obtain a status signal of the battery cell 7.

For example, the optical fiber 8 may be a single-mode optical fiber. During the operation of the battery 2, when there are temperature and thickness changes near the monitoring point of the optical fiber 8, the optical field of the fiber core mode of the optical fiber 8 is modulated, showing changes in the central wavelength of the Bragg (Bragg) mode spectrum and the intensity of the Ghost mode on the spectral demodulator as shown in FIG. 5. The axes of the first section 81 and the second section 82 of the optical fiber 8 are staggered. The second section 82 is in contact with the surface of the to-be-tested position of the electrode assembly 11, and the intensity of the Ghost mode in its spectrum linearly responds to strain. The second section 82 is not in contact with the surface of the to-be-tested position of the electrode assembly 11, thus avoiding the influence of strain on the Bragg mode wavelength of the single-mode optical fiber 8. Therefore, the changes in the intensity of the Ghost mode can be observed to analyze the strain condition of the to-be-tested position.

Further, due to the thermo-optic effect, the temperature change of the electrode assembly 11 causes simultaneous shifts in the central wavelength of the Bragg mode and the central wavelength of the Ghost mode of the optical fiber 8, but only the Bragg mode wavelength shift caused by temperature change is linear. Therefore, analyzing the changes in the central wavelength of the Bragg mode can obtain the temperature change of the to-be-tested position.

In the technical solution of the embodiments of this application, the optical fiber 8 includes the first section 81 and the second section 82 being connected to each other, and the first section 81 is attached to the electrode assembly 11, which can improve the detection sensitivity of the optical fiber 8 to the temperature or strain of the electrode assembly 11, thereby improving the accuracy and efficiency in monitoring the status of the battery cell 7. The second section 82 extends out of the housing to transmit the internal status information of the electrode assembly 11 to the outside. The axes of the first section 81 and the second section 82 are staggered, and the second section 82 does not contact the electrode assembly 11. Due to the photo-thermal effect, the central wavelength of the Bragg mode and the central wavelength of the Ghost mode of the single-mode optical fiber 8 change, and these changes can reflect the thickness changes and surface temperature changes of the electrode assembly 11. Therefore, the above structure can monitor the temperature change and strain of the battery cell 7 simultaneously, improving the operation safety and stability of the battery cell 7.

In some embodiments of this application, a diameter of the first section 81 is not equal to a diameter of the second section 82, or the diameter of the first section 81 is equal to the diameter of the second section 82. In the above technical solution, the diameters of the first section 81 and the second section 82 being equal facilitates the manufacturing and assembly of the optical fiber 8. The diameters of the first section 81 and the second section 82 being unequal is conducive to connecting one second section 82 to a plurality of first sections 81 simultaneously, thereby monitoring a plurality of monitoring points simultaneously. The above structure can be arranged as needed and is not limited hereto.

As shown in FIG. 5, in some embodiments of this application, the status signal obtained by the optical fiber 8 includes a Ghost signal X and a Bragg signal Y. The Ghost signal X is used for obtaining strain information of the battery cell 7 and the Bragg signal Y is used for obtaining temperature information of the battery cell 7. As changes in the Ghost signal X and Bragg signal Y of the single-mode optical fiber 8 are obtained to analyze the temperature change and strain of the electrode assembly, where these signals feature high sensitivity and fast speed in testing the strain and temperature changes of the battery cell 7, the change in status information of the battery cell 7 can be monitored effectively.

In some embodiments of this application, a length of the second section 82 is L₁, and 1 mm≤L₁≤2 cm. The second section 82 may be a communication quartz optical fiber, configured to connect the spectral demodulation system. Setting a reasonable length of the second section 82 can ensure the transmission of the information collected by the first section 81 while reducing the space occupied by the second section 82.

In some embodiments of this application, the first section 81 and the second section 82 are connected through welding. The welding for connection can ensure the stability of signal transmission in the optical fiber 8 and the connection strength between the first section 81 and the second section 82. Additionally, the welding is simple to operate, allowing for a high connection efficiency.

As shown in FIG. 6, in some embodiments of this application, the optical fiber 8 further includes a third section, the third section is connected to an end of the first section 81 away from the second section 82, and a Bragg grating is disposed on the third section.

The Bragg grating includes a plurality of refractive components arranged in the third section according to a certain regularity, and the Bragg grating of the optical fiber 8 selectively reflects a single wavelength from the wavelength band propagating in the optical fiber 8. Arranging the Bragg grating can obtain spectrum information including the Bragg mode and Ghost mode. The intensity change of the Ghost mode in the Bragg grating spectrum is in a certain strain relationship with strain, and the Bragg wavelength shift in the Bragg grating spectrum is in a certain strain relationship with temperature. A spectrometer analyzes the spectra of the two modes simultaneously to obtain the strain and temperature change information of the battery cell 7 under test.

As shown in FIG. 7, according to some embodiments of this application, the third section is adhered to the electrode assembly 11 using a tape 83. The tape 83 used for adhering can ensure the stability of the connection between the third section and the electrode assembly 11, improving the accuracy of information acquired by the optical fiber 8.

In some embodiments of this application, the third section and the second section 82 form an integral structure. The above structure can improve the manufacturing efficiency of the third section.

In some embodiments of this application, a length of the third section is L₂, and 1 mm≤L₂≤5 cm. Setting a reasonable length of the third section can ensure the accuracy of the spectral signal while minimizing the space occupied by the third section.

In some embodiments of this application, the electrode assembly 11 includes electrode plates and separators being stacked, and at least part of the third section is disposed between the electrode plate and the separator of the battery cell 7, or at least part of the third section is disposed between two of the separators of the battery cell 7. Setting the optical fiber 8 in the above position can more accurately obtain the local temperature and thickness changes during the operation of the battery cell 7, further improving the monitoring efficiency and accuracy of the battery cell 7.

In some embodiments of this application, such second section 82 is provided in plurality, the plurality of second sections 82 are connected to at least one such first section 81, and the second sections 82 are each connected to at least one such electrode assembly 11.

In some other embodiments of this application, such second section 82 is provided in plurality, the plurality of second sections 82 are connected to at least one such first section 81, and the plurality of second sections 82 are positioned at different positions on the same electrode assembly 11.

Each second section 82 can acquire information from at least one monitoring point, and the plurality of second sections 82 can acquire a plurality of pieces of monitoring information simultaneously. Based on the above structure, a plurality of monitoring points may be disposed on the same battery cell 7 or on a plurality of battery cells 7, respectively. The same first section 81 can connect a plurality of second sections 82. Monitoring points of the battery cell 7 are added to the foregoing structure, simplifying the structure of the first section 81, ensuring the transmission of spectral signals, simplifying the optical fiber structure 8, and improving the efficiency of information transmission.

In some embodiments, the optical fiber 8 is a single-mode optical fiber, which includes a core and a protective layer surrounding the core. The core diameter is greater than or equal to 4 µm (micrometers) and less than or equal to 9 µm. Preferably, the core diameter is 9 µm.

In some embodiments, the staggering distance H between the axis of the first section 81 and the axis of the second section 82 is 4 µm≤H≤9 µm. The staggering distance between the axis of the first section 81 and the axis of the second section 82 should be within a reasonable range to ensure signal transmission stability and also ensure that Ghost signals of different intensities can be obtained when the light is subjected to stress. Therefore, the staggering distance between the axis of the first section 81 and the axis of the second section 82 should not exceed the core diameter of the single-mode optical fiber.

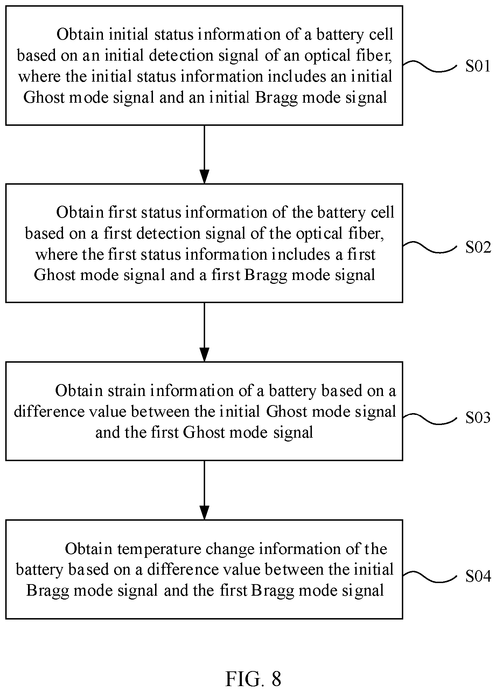

As shown in FIG. 8, an embodiment of this application provides a monitoring method for a battery cell, which is used for monitoring status information of the battery cell 7. The monitoring method for the battery 2 includes the following steps:
S01. Obtain initial status information of the battery cell based on an initial detection signal of an optical fiber, where the initial status information includes an initial Ghost mode signal and an initial Bragg mode signal.
S02. Obtain first status information of the battery cell based on a first detection signal of the optical fiber, where the first status information includes a first Ghost mode signal and a first detection signal.
S03. Obtain strain information of the battery 2 based on a difference between the initial Ghost mode signal and the first Ghost mode signal.
S04. Obtain temperature change information of the battery 2 based on a difference between the initial Bragg mode signal and the first Bragg mode signal.

Through the above detection method, pieces of information about local temperature change and thickness change of the battery cell 7 can be obtained simultaneously, with fast acquisition speed and high accuracy, enabling real-time monitoring of the status of the battery cell 7, and ensuring the safety and stability of operation of the battery cell 7.

In some embodiments of this application, the initial Ghost mode signal is a maximum intensity value M₀ of a Ghost mode spectrum at a time T₀, and the first Ghost mode signal is a maximum intensity value M₁ of the Ghost mode spectrum at a time T₁. A difference between the maximum intensity value M₀ of the Ghost mode spectrum at the initial time and the maximum intensity value M₁ of the Ghost mode spectrum at the time T₁ can be calculated to obtain thickness change information of the battery cell 7.

In some embodiments of this application, the initial Bragg mode signal is a wavelength λ₀ corresponding to a maximum intensity value of a Bragg mode spectrum at a time T₀ and the first Bragg mode signal is a wavelength λ₁ corresponding to a maximum intensity value of the Bragg mode spectrum at a time T₁. The difference between the wavelength λ₀ corresponding to the maximum intensity value of the Bragg mode spectrum at the time T₀ and the wavelength λ₁ corresponding to the maximum intensity value of the Bragg mode spectrum at the time T₁ can calculated to obtain the temperature change information of the battery cell 7.

In some embodiments of this application, the following steps are performed to obtain the temperature change information ΔT₁:
obtaining a wavelength difference Δλ₁ between the wavelength λ₁ corresponding to the maximum intensity value of the Bragg mode spectrum at the time T₁ and the wavelength λ₀ corresponding to the maximum intensity value of the Bragg mode spectrum at the time T₀, and
obtaining the temperature change information ΔT₁ based on the wavelength difference Δλ₁, where the temperature change information ΔT₁ is in a direct proportional relationship with the wavelength difference Δλ₁, and temperature changes by 1°C for every 10 pm-14 pm shift in a Bragg mode wavelength.

In some embodiments of this application, the following steps are performed to obtain the strain information ΔL₁:
obtaining an intensity difference ΔM₁ between the maximum intensity value M₀ of the Ghost mode spectrum at the time T₀ and the maximum intensity value M₁ of the Ghost mode spectrum at the time T₁,
obtaining stress information ΔF₁ based on the intensity difference ΔM₁, where the intensity difference ΔM₁ is in a direct proportional relationship with the stress information ΔF₁, and stress increases by 1 N for every 0.22-0.23 dB decrease in intensity, and
obtaining the strain information ΔL₁ based on the stress information ΔF₁ and a Young modulus of the optical fiber. For example, the strain information ΔL₁ (unit: µε)=ΔF₁/A*1000, where A represents the Young modulus of the optical fiber.

In the embodiments of this application, the spectrum information, obtained by the optical fiber 8, that includes the Bragg mode and the Ghost mode presents various situations:

First, the peaks of the Bragg mode and the Ghost mode shift, but the maximum intensity value of the Ghost mode spectrum remains unchanged. In this case, it is determined that the temperature at the monitoring point has changed, but no strain has occurred.

Second, the peaks of the Bragg mode and the Ghost mode shift, and the maximum intensity value of the Ghost mode spectrum decreases. It can be understood that when the maximum intensity value of the Ghost mode spectrum changes, it can be determined that a strain has occurred. Further, 1) when Δλ=0, it can be determined that only a strain has occurred at the monitoring point with no temperature change; 2) when Δλ>0, it can be determined that both temperature change and a strain have occurred at the monitoring point. At this time, the strain and the peak offset ΔX, of the Ghost mode and Bragg mode, that corresponds to the strain and affects the spectrum can be calculated first. Then, when the temperature change at the corresponding monitoring point is calculated, the actual offset should be subtracted by the peak offset ΔX caused by the strain to obtain the peak offset Δλ of the Bragg mode caused by the temperature change.

An embodiment of this application provides a battery 2, including the battery cell 7 in any of the above embodiments, a signal transmitting device, a signal receiving device, and a signal analyzing device. The signal transmitting device is connected to the second section 82 of the optical fiber 8 of the battery cell 7, where the signal transmitting device is configured to transmit a detection signal to the optical fiber 8. The signal receiving device is connected to the second section 82 of the optical fiber 8, where the signal receiving device is configured to receive a status signal transmitted back by the optical fiber 8. The signal analyzing device is connected to the signal receiving device and configured to convert the status signal to status information of the battery cell 7.

In the above technical solution, the signal transmitting device can transmit a signal to an optical fiber 8, the signal receiving device can receive a status signal reflected from the optical fiber 8, and the signal analyzing device converts the status signal into status information to obtain the real-time temperature change and thickness change values of the battery cell 7.

An embodiment of this application provides an electric apparatus, including the battery 2 in any one of the foregoing embodiments, where the battery 2 is configured to supply electrical energy.

Because the battery 2 and the electric apparatus in this application both include the battery cell 7 of the embodiments of this application, the above structure can monitor the temperature change and strain of the battery cell 7 simultaneously, improving the operation safety and stability of the battery cell 7. This is not elaborated herein.

### Embodiment 1

This embodiment provides a battery cell and a monitoring method for a battery cell. The battery cell includes a housing, an electrode assembly, and an optical fiber. The electrode assembly is accommodated in the housing. The optical fiber includes a first section and a second section. The first section is attached to the electrode assembly, the second section is connected to the first section and extends out of the housing, and an axis of the first section is staggered with an axis of the second section. The optical fiber is configured to obtain a status signal of the battery cell. The status signal obtained by the optical fiber includes a Ghost signal X and a Bragg signal Y. The Ghost signal is used for obtaining strain information of the battery cell and the Bragg signal is used for obtaining temperature information of the battery cell. A length of the second section is L₁, and 1 mm≤L₁≤2 cm. The first section and the second section are connected through welding. The optical fiber further includes a third section, the third section is connected to an end of the first section away from the second section, and a Bragg grating is disposed on the third section. The third section is adhered to an electrode assembly using a tape. The third section and the second section form an integral structure. A length of the third section is L₂, and 1 mm≤L₂≤5 cm. The electrode assembly includes electrode plates and separators stacked together, with at least part of the third section positioned between two separators of the battery cell.

An end of the first section away from the housing is connected to the signal transmitting device, the signal receiving device, and the signal analyzing device. The signal transmitting device can transmit a signal to an optical fiber, the signal receiving device can receive a status signal reflected from the optical fiber, and the signal analyzing device converts the status signal into status information to obtain the real-time temperature change and thickness change values of the battery cell.

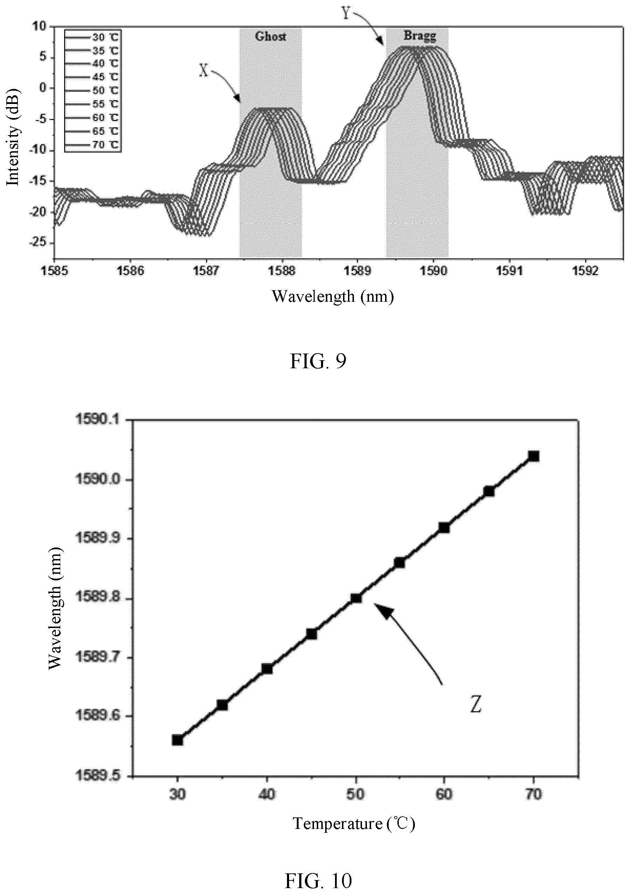

The signal transmitting device transmits a signal to the optical fiber, and a temperature sensor is arranged within the battery cell to obtain the real-time temperature of the electrode assembly. As shown in FIG. 9, the Ghost mode signal and Bragg mode signal at different temperatures are obtained using the signal receiving device.

From FIG. 9, it can be known that as the temperature increases, the intensity of the Ghost mode does not change significantly, and the intensity of the Bragg mode neither changes significantly. However, the wavelength shows a significant drift with the temperature change, presenting a linear change. Referring to FIG. 10, line Z is a fitting curve of the Bragg wave peak with temperature change according to FIG. 9. The Bragg wave peak shifts to the right as the temperature increases, with a sensitivity of approximately 12 pm (Picometer) per 1°C increase.

### Embodiment 2

This embodiment provides a battery cell and a monitoring method for a battery cell, where the battery cell in this embodiment is the same as that in Embodiment 1, and the battery cell in this embodiment is provided with no temperature sensor.

The battery cell is charged and discharged at three different rates, and the detection signals of the optical fiber at different times are obtained using a signal device and converted into temperature signals. The monitoring results are shown in Table 1.

**Table 1**

| Rate (C) | Bragg wavelength offset (pm) | Temperature Change (°C) |
|---|---|---|
| 0.33 | 18 | 1.8 |
| 0.75 | 51 | 5.1 |
| 1 | 122 | 12.2 |

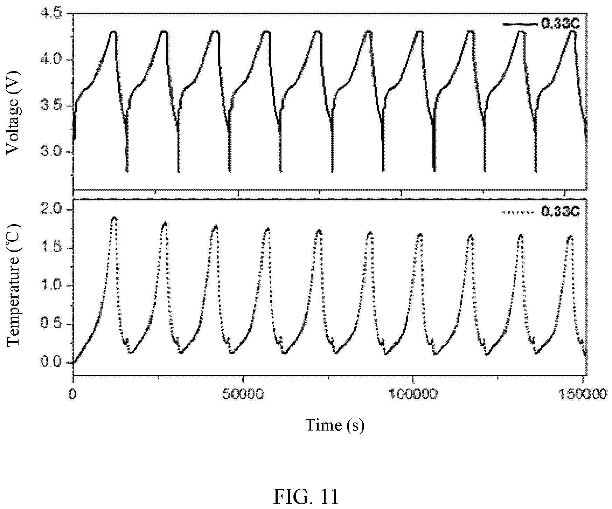

Refer to FIGs. 11 to 13, which are temperature change graphs of the battery cell during charge and discharge at different rates.

As shown in FIG. 11 being of a curve, the temperature of the battery cell changes with voltage at a charge and discharge rate of 0.33C. As the voltage increases, the temperature of the battery cell increases significantly, and as the voltage decreases, the temperature of the battery cell also decreases.

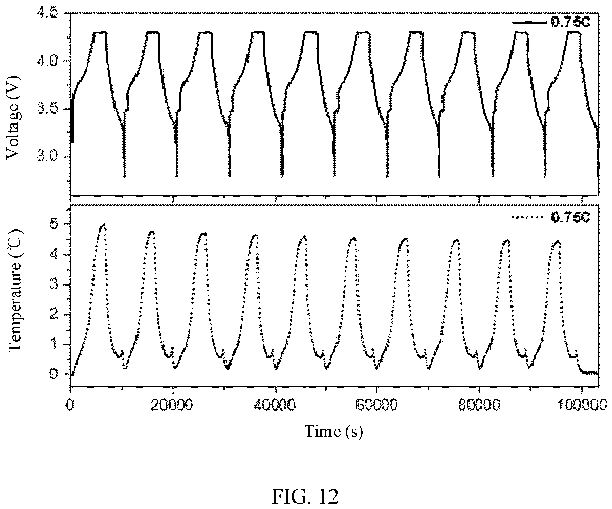

As shown in FIG. 12 being of a curve, the temperature of the battery cell changes with voltage at a charge and discharge rate of 0.75C. As the voltage increases, the temperature of the battery cell increases significantly, and as the voltage decreases, the temperature of the battery cell also decreases.

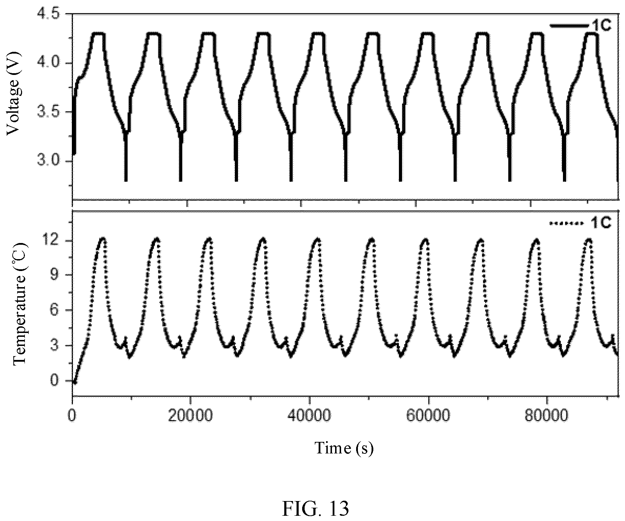

As shown in FIG. 13 being of a curve, the temperature of the battery cell changes with voltage at a charge and discharge rate of 1.0C. As the voltage increases, the temperature of the battery cell increases significantly, and as the voltage decreases, the temperature of the battery cell also decreases.

The above test results are consistent with the actual temperature change patterns of the battery cell. Therefore, the battery cell provided in this embodiment of this application can accurately and efficiently monitor temperature change of the battery cell. This can ensure the safety and stability of the battery cell during operation. Moreover, the battery cell of this application has a simple structure and is easy to promote and apply.

### Embodiment 3

This embodiment provides a battery cell and a monitoring method for a battery cell, where the battery cell in this embodiment is the same as that in Embodiment 1, and the battery cell in this embodiment is provided with no temperature sensor.

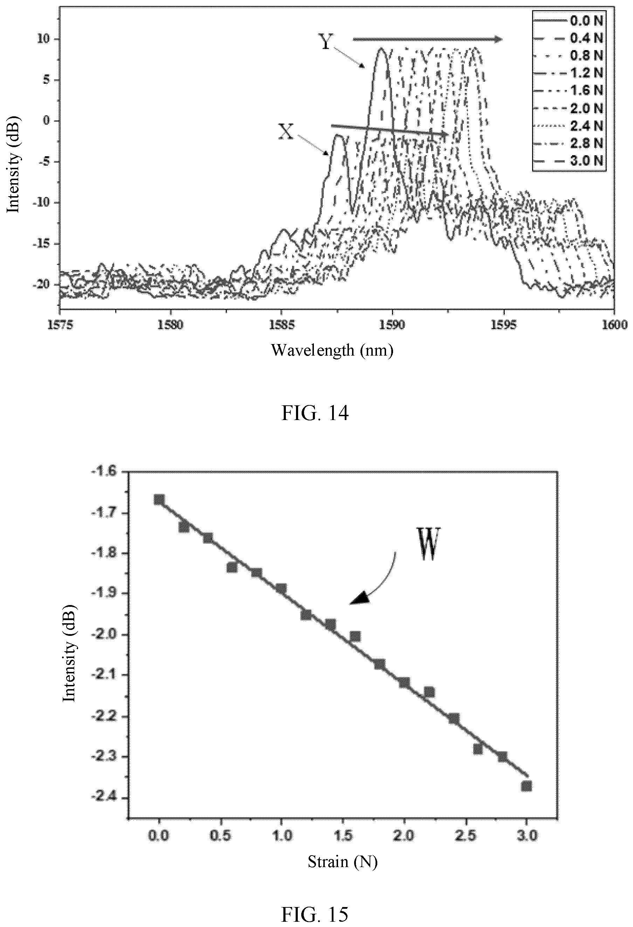

The signal transmitting device transmits a signal to the optical fiber and applies different pressures to the battery cell. As shown in FIG. 14, the Ghost mode signals and Bragg mode signals under different pressures are obtained using the signal receiving device.

From FIG. 14, it can be known that both the Ghost mode peak and the Bragg mode peak show a certain shift as the pressure increases. Additionally, the intensity of the Bragg mode also changes significantly, and the intensity of the Ghost mode shows a trend of gradually decreasing as the pressure increases. Referring to FIG. 15, line W is a fitting curve of a Ghost mode peak intensity with pressure change in FIG. 14. The intensity of the Ghost mode peak shifts downward as the pressure increases, with a sensitivity of approximately 0.222 dB per 1 N increase.

### Embodiment 4

This embodiment provides a battery cell and a monitoring method for a battery cell, where the battery cell in this embodiment is the same as that in Embodiment 1, and the battery cell in this embodiment is provided with no temperature sensor.

The battery cell is charged and discharged at three different rates, and the detection signals of the optical fiber at different times are obtained using a signal device and converted into pressure signals. The monitoring results are shown in Table 2.

**Table 2**

| Rate (C) | Ghost intensity change (dB) | Stress change (N) | Strain (µε) |
|---|---|---|---|
| 0.33 | -38.61--40.68 | 0-6 | 0-85.71 |
| 0.75 | -38.98--40.28 | 0-10 | 0-142.86 |
| 1 | -39.39--42.27 | 0-13 | 0-185.71 |

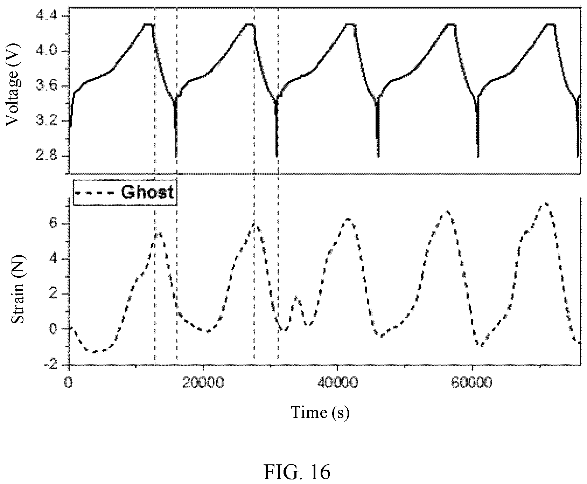

Refer to FIGs. 16 to 18, which are strain change graphs of the battery cell during charge and discharge at different rates. Strain calculation formula: ΔL₁=ΔF₁/A*1000, where ΔL₁ represents strain at a monitoring point, ΔF₁ represents stress at a single monitoring point, and A represents Young modulus of an optical fiber. In this embodiment, the Young modulus of the optical fiber is 70.

As shown in FIG. 16 being of a curve, the stress of the battery cell changes with voltage at a charge and discharge rate of 0.33C. According to the conversion formula of stress and strain, it can be calculated that as the voltage increases, the battery cell shows a significant rise in strain, and as the voltage decreases, the strain of the battery cell also decreases.

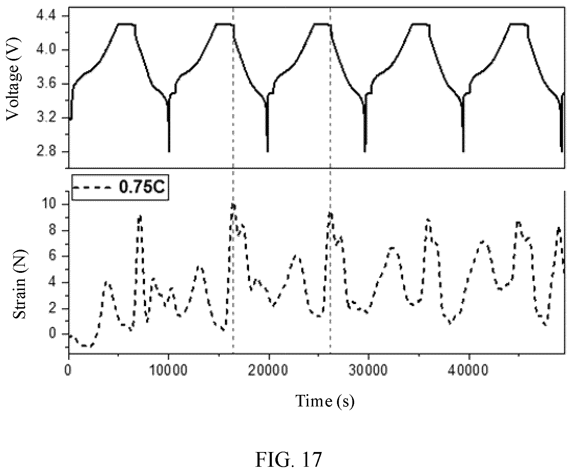

As shown in FIG. 17 being of a curve, the stress of the battery cell changes with voltage at a charge and discharge rate of 0.75C. According to the conversion formula of stress and strain, it can be calculated that as the voltage increases, the battery cell shows a significant rise in strain, and as the voltage decreases, the strain of the battery cell also decreases.

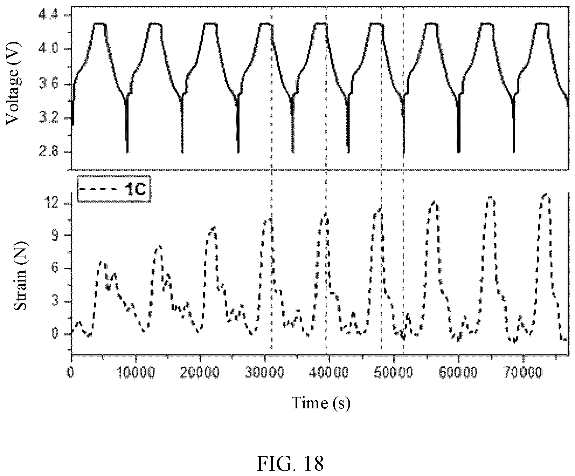

As shown in FIG. 18 being of a curve, the stress of the battery cell changes with voltage at a charge and discharge rate of 1.0C. According to the conversion formula of stress and strain, it can be calculated that as the voltage increases, the battery cell shows a significant rise in strain, and as the voltage decreases, the strain of the battery cell also decreases.

The above test results are consistent with the actual strain change patterns of the battery cell. Therefore, the battery cell provided in this embodiment of this application can accurately and efficiently monitor strain change of the battery cell. This can ensure the safety and stability of the battery cell during operation. Moreover, the battery cell of this application has a simple structure and is easy to promote and apply.

Although this application has been described with reference to the preferred embodiments, various modifications to this application and replacements of the components therein with equivalents can be made without departing from the scope of this application. In particular, as long as there is no structural conflict, the various technical features mentioned in the embodiments can be combined in any manner. This application is not limited to the specific embodiments disclosed in this specification but includes all technical solutions falling within the scope of the claims.

## Claims

1. A battery cell, comprising:
a housing;
an electrode assembly accommodated in the housing; and
an optical fiber comprises a first section and a second section, wherein the first section is attached to the electrode assembly, the second section is connected to the first section and extends out of the housing, an axis of the first section is staggered with an axis of the second section, and the optical fiber is configured to obtain a status signal of the battery cell.

2. The battery cell according to claim 1, wherein the status signal comprises a Ghost signal and a Bragg signal, wherein the Ghost signal is used for obtaining strain information of the battery cell and the Bragg signal is used for obtaining temperature information of the battery cell.

3. The battery cell according to claim 2, wherein a diameter of the first section is not equal to a diameter of the second section, or the diameter of the first section is equal to the diameter of the second section.

4. The battery cell according to claim 2, wherein a length of the second section is L₁, and 1 mm≤L₁≤2 cm.

5. The battery cell according to claim 2, wherein the first section and the second section are connected through welding.

6. The battery cell according to claim 2, wherein the optical fiber further comprises a third section, the third section is connected to an end of the first section away from the second section, and a Bragg grating is disposed on the third section.

7. The battery cell according to claim 6, wherein the third section and the second section form an integral structure.

8. The battery cell according to claim 6, wherein a length of the third section is L₂, and 1 mm≤L₂≤5 cm.

9. The battery cell according to any one of claims 6 to 8, wherein the electrode assembly comprises electrode plates and separators being stacked, and at least part of the third section is disposed between the electrode plate and the separator of the battery cell, or at least part of the third section is disposed between two of the separators of the battery cell.

10. The battery cell according to claim 9, wherein such second section is provided in plurality, the plurality of second sections are connected to at least one such first section, and the second sections are each connected to at least one such electrode assembly.

11. A monitoring method for a battery cell, used for monitoring status information of the battery cell, wherein the monitoring method comprises:
obtaining initial status information of the battery cell based on an initial detection signal of an optical fiber, wherein the initial status information comprises an initial Ghost mode signal and an initial Bragg mode signal;
obtaining first status information of the battery cell based on a first detection signal of the optical fiber, wherein the first status information comprises a first Ghost mode signal and a first Bragg mode signal;
obtaining strain information of a battery based on a difference between the initial Ghost mode signal and the first Ghost mode signal; and
obtaining temperature change information of the battery based on a difference between the initial Bragg mode signal and the first Bragg mode signal.

12. The monitoring method according to claim 11, wherein the initial Ghost mode signal is a maximum intensity value M₀ of a Ghost mode spectrum at a time T₀, and
the first Ghost mode signal is a maximum intensity value M₁ of the Ghost mode spectrum at a time T₁.

13. The monitoring method according to claim 11, wherein the initial Bragg mode signal is a wavelength λ₀ corresponding to a maximum intensity value of a Bragg mode spectrum at a time T₀ and
the first Bragg mode signal is a wavelength λ₁ corresponding to a maximum intensity value of the Bragg mode spectrum at a time T₁.

14. The monitoring method according to any one of 11 to 13, wherein the following steps are performed to obtain the temperature change information ΔT₁:
obtaining a wavelength difference Δλ₁ between the wavelength λ₁ corresponding to the maximum intensity value of the Bragg mode spectrum at the time T₁ and the wavelength λ₀ corresponding to the maximum intensity value of the Bragg mode spectrum at the time T₀, and
obtaining the temperature change information ΔT₁ based on the wavelength difference Δλ₁, wherein the temperature change information ΔT₁ is in a direct proportional relationship with the wavelength difference Δλ₁, and temperature changes by 1°C for every 10 pm-14 pm shift in a Bragg mode wavelength.

15. The monitoring method according to any one of 12 to 14, wherein the following steps are performed to obtain the strain information ΔL₁:
obtaining an intensity difference ΔM₁ between the maximum intensity value M₀ of the Ghost mode spectrum at the time T₀ and the maximum intensity value M₁ of the Ghost mode spectrum at the time T₁,
obtaining stress information ΔF₁ based on the intensity difference ΔM₁, wherein the intensity difference ΔM₁ is in a direct proportional relationship with the stress information ΔF₁, and stress increases by 1 N for every 0.22-0.23 dB decrease in intensity, and
obtaining the strain information ΔL₁ based on the stress information ΔF₁ and a Young modulus of the optical fiber.

16. A battery, comprising:
the battery cell according to any one of claims 1 to 10; and
a signal transmitting device connected to the second section of the optical fiber of the battery cell, wherein the signal transmitting device is configured to transmit a detection signal to the optical fiber;
a signal receiving device connected to the second section of the optical fiber, wherein the signal receiving device is configured to receive a status signal transmitted back by the optical fiber; and
a signal analyzing device connected to the signal receiving device and configured to convert the status signal to status information of the battery cell.

17. An electric apparatus, wherein the electric apparatus comprises the battery according to claim 16, and the battery is configured to supply electrical energy.
